# EUROPÄISCHE PATENTSCHRIFT

(11) **EP 0 579 025 B1**
(45) Veröffentlichungstag und Bekanntmachung des Hinweises auf die Patenterteilung: **06.09.2000**
(21) Anmeldenummer: 93110323.8
(22) Anmeldetag: 29.06.1993
(51) Int. Cl.: H03M 1/66

(54) **Digital-Analog-Wandler mit gewichtetem kapazitiven Wandlernetzwerk**
Digital-analog converter with weighted capacitive network
Convertisseur numérique-analogique à réseau capacitif pondéré

(30) Priorität: 13.07.1992 DE 4223000
(43) Veröffentlichungstag der Anmeldung: 19.01.1994
(73) Patentinhaber: SIEMENS AKTIENGESELLSCHAFT, 80333 München (DE)
(72) Erfinder: Draxelmayr, Dieter, Dr., Dipl.-Ing., A-9500 Villach (AT)

(56) Entgegenhaltungen:
- EP-A- 0 078 608
- EP-A- 0 169 535
- EP-A- 0 170 224
- FR-A- 2 314 617
- US-A- 4 947 169

## Beschreibung

Die Erfindung betrifft einen Digital-Analog-Wandler mit einem gewichteten kapazitiven Wandlernetzwerk.

Kapazitive Digital-Analog-Wandler sind seit langem bekannt, beispielsweise aus dem Buch von D. Seitzer: "Elektronische Analog-Digital-Umsetzer", Springer-Verlag, Berlin, 1977, Seite 82 f. Ein von einer digitalen Information gesteuerter Schalter lädt in einer ersten Taktperiode eine Kapazität auf. Während einer zweiten Taktperiode wird der Schalter geöffnet und über einen weiteren Schalter eine weitere Kapazität parallelgeschaltet, so daß sich die in der ersten Taktperiode gespeicherte Ladung auf beide Kapazitäten verteilt. Der Schalter und die Kapazität können durch ein Schalternetzwerk und ein gewichtetes kapazitives Netzwerk ersetzt werden. Grundprinzipien gewichteter Netze für D/A-Wandler sind beispielsweise aus U. Tietze, Ch. Schenk: "Halbleiter-Schaltungstechnik", Springer-Verlag, Berlin, 7. Aufl., 1985, Seite 739 ff. bekannt.

Einem D/A-Wandler nach dem Prinzip der Ladungsumverteilung mit gewichtetem kapazitiven Netzwerk wird bei bestimmten Anwendungen ein zeitkontinuierliches Interpolationsfilter, d.h. ein Tiefpaß nachgeschaltet. Aufgrund des zeitkontinuierlichen Filters wird die Ausgangsspannung des Digital-Analog-Wandlers zeitkontinuierlich, d.h. zu allen Zeiten bewertet. Damit hat das Einschwingverhalten des Wandlers einen wesentlichen Einfluß auf das erzielbare Wandlungsergebnis. Grundsätzlich besteht das Ziel, bei der Wandlung ein und derselben Digitalcodes am Ausgang des zeitkontinuierlichen Filters einen Analogwert zu erhalten, der genau dem Digitalcode entspricht.

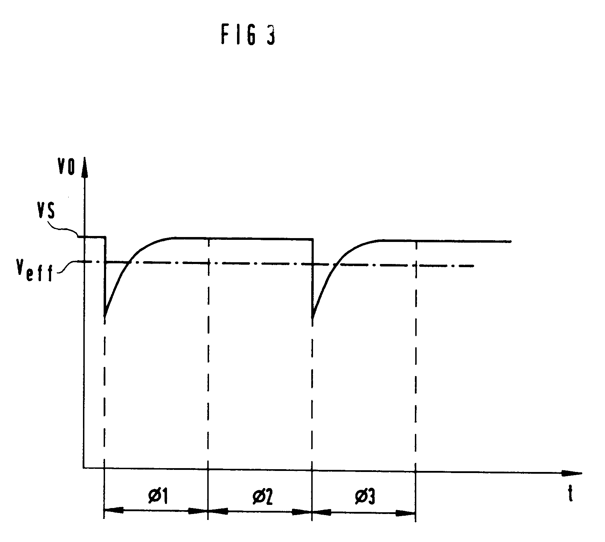

In der Praxis jedoch kann die einem Digitalcode zugeordnete Ausgangsspannung aufgrund von Schaltspitzen der Schalter des Wandlers verfälscht sein, wie dies Figur 3 schematisch erläutert. Der Sollwert der Ausgangsspannung VS bricht zu Beginn jeder ersten Taktperiode φ1, die das gewichtete Netzwerk steuert, kurzzeitig zusammen und erreicht dann den Sollwert. Aus dem Signalverlauf ergibt sich eine gegenüber der Soll-Ausgangsspannung V_{S} verringerte effektive Ausgangsspannung V_{eff}.

In einem Wandler der geschilderten Art tritt dieses Phänomen der Schaltspitzen besonders störend bei Übergängen von einem Code zum nächsten dann auf, wenn sich mehrere oder viele Elemente des Codes ändern. Dies ist beispielsweise beim Übergang von einem Code 01111 zu einem Code 10000 der Fall. Dies ist dadurch begründet, daß besagte Schaltspitzen stark mit den einzelnen Bits korreliert sind. Bei Änderung vieler Bits ändert sich auch die Schaltspitze stark. Insgesamt ergibt der parasitäre Effekt eine starke Nichtlinearität in der Kennlinie des D/A-Wandlers.

Grundsätzlich ist es schwierig, Nichtlinearitäten völlig zu vermeiden. Wünschenswert ist aber eine Kennlinie mit einer Form, die eine gute Linearität ermöglicht. Andere Kennlinienstörungen, wie etwa ein Verstärkungsfehler, spielen bei D/A-Wandlern wie auch bei den meisten nachrichtentechnischen Anwendungen keine so große Rolle wie Nichtlinearitäten.

In integrierten D/A-Wandlern wird oft das Wandlernetzwerk in zwei kapazitive Teilnetzwerke aufgespalten, die über eine Koppelkapazität verbunden sind. Ein D/A-Wandler mit Grundsätzlich ist es schwierig, Nichtlinearitäten völlig zu vermeiden. Wünschenswert ist aber eine Kennlinie mit einer Form, die eine gute Linearität ermöglicht. Andere Kennlinienstörungen, wie etwa ein Verstärkungsfehler, spielen bei D/A-Wandlern wie auch bei den meisten nachrichtentechnischen Anwendungen keine so große Rolle wie Nichtlinearitäten.

In integrierten D/A-Wandlern wird oft das Wandlernetzwerk in zwei kapazitive Teilnetzwerke aufgespalten, die über eine Koppelkapazität verbunden sind. Ein D/A-Wandler mit einem ungeteilten kapazitiven Netzwerk wird typischerweise eine verbesserte Linearitätskennlinie besitzen. Die Verwendung eines ungeteilten kapazitiven Netzwerkes bedeutet aber die Verwendung auch größerer Kapazitäten, die wiederum eine dramatische Vergrößerung der benötigten Chipfläche bedeuten.

Eine weitere Möglichkeit zur Verbesserung der Linearitätskennlinie besteht darin, die Einschwingzeit zu verkürzen. Dann wird die Zeit, in der ein gestörtes Signal anliegt, minimiert, wie dies aus Figur 3 zu erklären ist. Allerdings benötigt ein derartiger Lösungsweg wesentlich mehr Leistung als das entsprechende ursprüngliche Wandlungssystem. Besonders bei schnellen Wandlern kann darüber hinaus dieser Weg nicht realisierbar sein.

Aus EP-A-0 078 608 ist ein A/D-Wandler bekannt, der ein gewichtetes kapazitives Netzwerk aufweist, dessen Kapazitätswerte binär gewichtet sind. Um eine exakte Abstufung der binären Gewichtung zu erreichen, ist bei diesem A/D-Wandler eine Schaltung zur elektronischen Kompensation von Abweichung der Kapazitätswerte von den exakten binären Gewichtungen vorgesehen. Um die Abweichungen der Kapazitätswerte von den exakten binären Gewichtungen festzustellen, wird von der Schaltung in einer Initialisierungsphase für jede einzelne Kapazität des gewichteten kapazitiven Netzwerks die Abweichung festgestellt und gespeichert. Nachteilig ist dabei jedoch der hohe schaltungstechnische Aufwand zur Feststellung und Speicherung der Abweichungen.

Schließlich ist es zur Verbesserung des Linearitätsverhaltens auch möglich, dem D/A-Wandler und dem nachgeschalteten Filter ein Abtast- und Halteglied nachzuschalten, das den Sollwert des Wandlers abtastet und während der Zeit konstant hält, in der Schaltspitzen auftreten können. Diese Lösungsmöglichkeit bedeutet jedoch einen erheblichen schaltungstechnischen Aufwand, da das Abtast- und Halteglied zusätzlich integriert werden muß.

Der Erfindung liegt die Aufgabe zugrunde, einen Digital- Analog-Wandler mit gewichtetem kapazitiven Wandlernetzwerk anzugeben, der bei geringer benötigter Chipfläche eine niedrige Leistungsaufnahme und gute Linearitätskennlinie aufweist.

Diese Aufgabe wird mit den Merkmalen des Patentanspruchs 1 gelöst.

Ausgestaltungen der Erfindung sind in Unteransprüchen gekennzeichnet.

Die Erfindung wird nachfolgend anhand der Figuren der Zeichnung näher erläutert. Es zeigen:
- Figur 1: ein Blockschaltbild des Digital-Analog-Wandlers,
- Figur 2: eine detaillierte Schaltung des beanspruchten Wandlernetzwerks und
- Figur 3: Diagramme zur Erläuterung des der Erfindung zugrundeliegenden Problems.

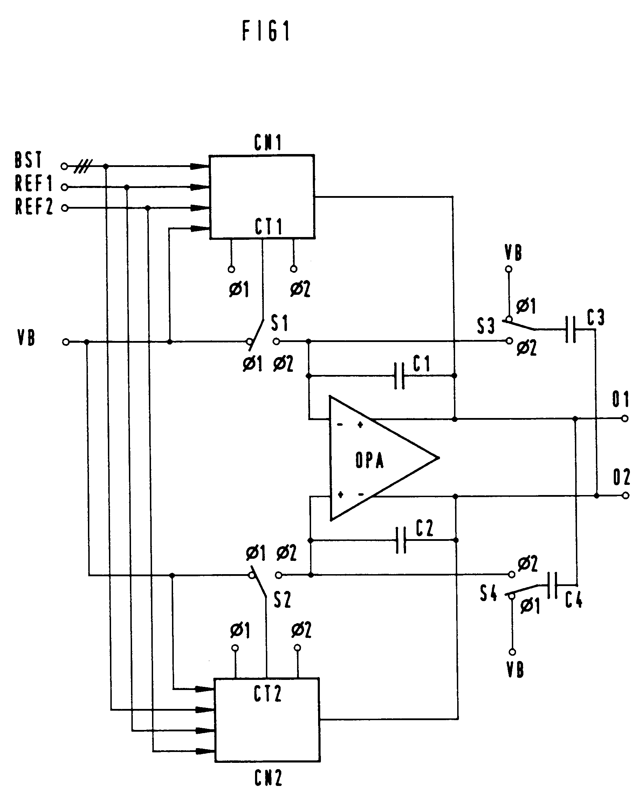

Figur 1 zeigt als Blockschaltbild einen erfindungsgemäßen Digital-Analog-Wandler. Der Wandler ist vollständig differentiell aufgebaut. Das bedeutet, daß die Beschaltung eines Operationsverstärkers OPA bezüglich der invertierenden und nichtinvertierenden Anschlüsse symmetrisch ist. Der Operationsverstärker ist mit vier Kapazitäten C1 bis C4 und zwei Wandlernetzwerken CN1 und CN2 beschaltet. Die Kapazitäten C1 und C3 sowie C2 und C4 sind jeweils gleich. Die Anordnung arbeitet mit einem zweiphasigen Takt φ1 und φ2, der von einem nicht dargestellten Taktgenerator erzeugt wird. Eingangsgrößen für die Kapazitätsnetzwerke sind die Referenzpotentiale REF1 sowie REF2, ein Bezugspotential VB und ein Steuerbus BST, der die zu wandelnde digitale Information enthält. Die Kapazitätsnetzwerke und die Schalter S1 bis S4 werden von den Takten φ1 und φ2 gesteuert.

Die Beschaltung für den invertierenden Eingang - und den nichtinvertierten Ausgang + des Operationsverstärkers OPA sieht zwischen diesen beiden Anschlüssen die Kapazität C1 vor. Der invertierende Eingang ist weiterhin beim Takt φ2 über den Schalter S1 mit dem Knotenpunkt CT1 des Kapazitätsnetzwerks CN1 verbunden und über den Schalter S3 mit der Kapazität C3. Die Kapazität C3 ist mit ihrem anderen Anschluß am invertierten Ausgang O2 des Operationsverstärkers angeschlossen. Beim Takt φ1 sind die Schalter S1 und S3 mit dem Bezugspotential VB verbunden, so daß die Kapazität C3 und der Knotenpunkt CT1 des Kapazitätsnetzwerks CN1 mit dem Bezugspotential verbunden sind. Der nichtinvertierte Ausgang + des Operationsverstärkers OPA ist an den Ausgangsanschluß O1 und einen Anschluß des Kapazitätsnetzwerks CN1 angeschlossen. In entsprechender Weise sind der nichtinvertierende Eingang + und der invertierte Ausgang - des Operationsverstärkers OPA gemäß Figur 1 beschaltet.

Während des Takts φ1 werden die Kapazitätsnetzwerke CN1 und CN2 entsprechend des anliegenden Digitalcodes auf die Referenzpotentiale REF1, REF2 und VB aufgeladen. Diese Referenzpotentiale können beispielsweise die positive und negative Eingangsreferenzspannung sein, wenn das Bezugspotential VB das Massepotential ist. Gleichzeitig behalten mit dem Takt φ1 die Ausgänge O1 und O2 des Operationsverstärkers dieselben Werte wie in der vorausgegangenen Taktperiode. Die Kapazitäten C3 und C4 werden deshalb auf die Ausgangspotentiale der Ausgänge O1 und O2 geladen.

Während des Takts φ2 wird jeweils ein Anschluß der Kapazitäten C4 und C3 über den Schalter S4 bzw. S3 an den nichtinvertierenden bzw. invertierenden Eingang des Operationsverstärkers gelegt. Als Konsequenz dieser Rückkopplung folgt, daß die Ladungen auf den Kapazitäten C3 bzw. C4 die Ladungen auf den Kapazitäten C1 bzw. C2 kompensieren. Gleichzeitig erfolgt eine neue Ladungsumverteilung zwischen den Kapazitäten C1 und C3 bzw. C2 und C4, wenn die Kapazitätsnetzwerke CN1 und CN2 über die Schalter S1 und S2 in den Rückkopplungspfad geschaltet werden. Die auf den Kapazitätsnetzwerken CN1 und CN2 gespeicherten Ladungen werden deshalb nicht umverteilt, so daß die Ausgangsanschlüsse O1 und O2 den analogen Spannungswert annehmen, der dem letzten digitalen Eingangssignal für die Kapazitätsnetzwerke während des Takts φ1 entspricht. Es ist hinzuzufügen, daß die Kapazitätswerte sehr niedrig gewählt werden können, weil sie allein durch die Genauigkeit der Kompensation zwischen C1 und C3 bzw. C2 und C4 begrenzt sind.

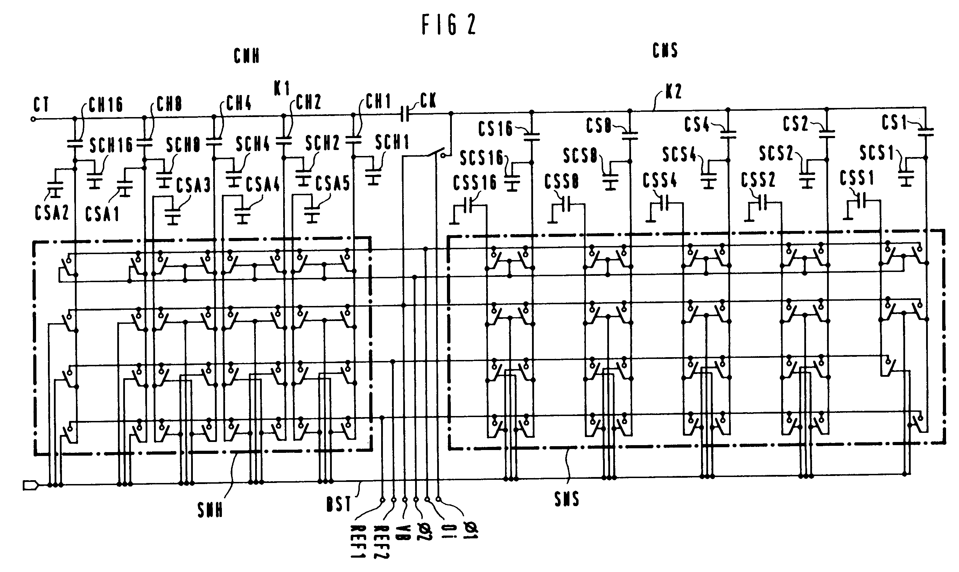

Figur 2 zeigt eines der beiden Kapazitätsnetzwerke im Detail. Jedes Kapazitätsnetzwerk enthält ein Hauptnetzwerk CNH und ein Teil- oder Split-Netzwerk CNS. Die beiden Netzwerksteile sind über eine Koppelkapazität CK miteinander verbunden. Jedes Teilnetzwerk enthält gewichtete Kapazitäten CH1 bis CH16 bzw. CS1 bis CS16. Die Netzwerksanordnung stellt nur ein Beispiel der Erfindung dar. Selbstverständlich können die Kapazitäten auch anders auf die Teilnetzwerke aufgeteilt sein, oder es kann auch ohne Teilnetzwerk nur ein ungeteiltes Netzwerk vorgesehen sein. Die Kapazitäten CHi des Hauptnetzwerks sind mit jeweils einem Anschluß an einem gemeinsamen Knotenpunkt K1 bzw. an dem Anschluß CT angeschlossen. Mit ihrem jeweils anderen Anschluß sind die gewichteten Kapazitäten des Hauptnetzwerks mit einem Schalternetzwerk SNH verbunden.

Die gewichteten Kapazitäten CSi des Split-Netzwerks CNS sind mit jeweils einem Anschluß an einem zweiten gemeinsamen Knoten K2 angeschlossen, der über einen vom Takt φ1 getakteten Schalter mit dem Bezugspotential VB verbindbar ist. Dieser Schalter kann auch entfallen. Zwischen den beiden Knoten K1 und K2 liegt die Koppelkapazität CK. Die jeweils anderen Anschlüsse der gewichteten Kapazitäten des Split-Netzwerks sind mit einem zugehörigen Schalternetzwerk SNS verbunden.

Im Ausführungsbeispiel der Figur 2 hat jedes Schalternetzwerk vier Schalterebenen. Die Schalter dreier Schalterebenen werden über den Steuerbus BST gesteuert, so daß abhängig vom angelegten Digitalcode jeweils eines der Potentiale REF1, REF2 oder VB mit dem zugehörigen Anschluß einer der gewichteten Kapazitäten des Hauptnetzwerks oder des Split-Netzwerks verbunden werden kann. Die vierte Schalterebene wird vom Takt φ2 gesteuert und kann den zugehörigen Ausgang O1 oder O2 des Operationsverstärkers OPA mit dem jeweiligen Anschluß der gewichteten Kapazitäten verbinden. Die Knotenpunkte K1 und K2 sind über den Anschluß CT mit einem der Eingangsanschlüsse des Operationsverstärkers oder mit dem Bezugspotential VB verbindbar, wie dies in Fig. 1 beschrieben ist.

In Figur 2 sind zusätzlich zu den gewichteten Nutzkapazitäten CH1 bis CH16 bzw. CS1 bis CS16 auch Streukapazitäten SCH1 bis SCH16 für das Hauptnetzwerk CNH sowie die Streukapazitäten SCS1 bis SCS16 für das Split-Netzwerk CNS eingezeichnet. Diese Streukapazitäten ergeben sich beispielsweise aus der Verdrahtung oder dem technologischen Aufbau der Nutzkapazitäten. Während der Vorladephase des Taktes φ1 werden die Streukapazitäten der Kapazitätsnetzwerke entweder auf ein Referenzpotential oder das Bezugspotential VB geladen. Während des Übergangs vom Takt φ1 auf den Takt φ2 müssen die Streukapazitäten auf die analogen schlußendlichen Ausgangsspannungen des Operationsverstärkers umgeladen werden. Die dazu erforderliche Leistung hat im wesentlichen der Operationsverstärker OPA zu erbringen.

Die Erfindung setzt bei der Erkenntnis an, daß die in Verbindung mit Figur 3 geschilderten Nichtlinearitäten in hohem Maße auf die Streukapazitäten zurückzuführen sind. Die Erfindung sieht deshalb vor, parallel zu den vorhandenen Streukapazitäten zusätziche Streukapazitäten deart anzuordnen, daß die Gesamtstreukapazitäten gewichtet sind. Bei derartigen entsprechend den Nutzkapazitäten gewichteten Streukapazitäten ist die effektive Ladung aller parasitärer Streukapazitäten dann proportional zur Ausgangsspannung an den Ausgangsanschlüssen des Operationsverstärkers. Weiterhin ist eine optimale Abstimmung der Zeitkonstanten aus dem jeweiligen Schalterwiderstand und der zugehörigen Streukapazität möglich. Dadurch, daß die effektive Ladung aller Streukapazitäten proportional zur Ausgangsspannung ist, kann sich lediglich ein Verstärkungsfehler ergeben, da das Einschwingverhalten auf den jeweiligen Digitalcode abgestimmt ist.

Bei einem Wandler mit binär gewichteten Nutzkapazitäten bedeutet die Lehre der Erfindung, daß die Parasitärkapazitäten ebenfalls binär gewichtet sein müssen. Üblicherweise ist das nämlich nicht der Fall. Besonders kraß wird dieses Mißverhältnis üblicherweise zwischen dem Haupt- und dem Split-Netzwerk.

In einer Ausgestaltung der erfindungsgemäßen Lehre ist vorgesehen, die richtige Gewichtung der parasitären Streukapazitäten dadurch zu erreichen, daß zusätzliche parasitäre Kapazitäten zu den bereits vorhandenen Streukapazitäten parallelgeschaltet werden, bis eine entsprechende, beispielsweise binäre Gewichtung erreicht ist. Figur 2 zeigt die zusätzlichen Streukapazitäten CSA1 und CSA2 des Netzwerkes SNH. Üblicherweise geht man dabei von der Streukapazität des niedrigstwertigen Bits LSB aus. Daran anschließend werden die parasitären Kapazitäten der höherwertigen Bits jeweils von Stufe zu Stufe verdoppelt. Da allerdings die Streukapazität des niedrigstwertigen Bits LSB meistens relativ groß ist, erfordert dieses Vorgehen aufgrund der stufenweisen Verdopplung der Streukapazitäten auch bei den in der Anordnung gemäß Figur 1 vorgesehenen niedrigen Kapazitäten insgesamt vergleichsweise hohe Kapazitäten und damit eine große Chipfläche.

In einer anderen Ausgestaltung der Erfindung ist vorgesehen, von der Streukapazität eines höherwertigen Bits auszugehen und entsprechend der erforderlichen Gewichtung die Streukapazitäten der niedriger gewichteten Bits zu verringern. Dies wird möglich, indem den Streukapazitäten der niedrigerwertigen Bits eine Streukapazität mit effektiv, d.h. in ihrer Wirkung negativer Kapazität während der zweiten Taktperiode parallelgeschaltet wird. Bei einer Anordnung gemäß Figur 1, die vollständig differentiell aufgebaut ist, so daß jedes Signal auch invertiert vorhanden ist, wird eine Parallelschaltung einer negativen Effektivkapazität durch Parallelschalten einer Kapazität mit gegenphasiger Ansteuerung realisiert. Durch die gegenphasige Ansteuerung der beiden Kapazitäten kann der gewünschte Teil der Fehlerladung kompensiert werden, was nach außen insgesamt als Kapazitätsverringerung wirkt. Fig. 2 zeigt die Kompensations-Streukapazititen CSS1 bis CSS16 des Teilnetzwerkes SNS, die als negative Kapazitäten wirken. Man kann deshalb bei der Ausbildung der gewichteten Parasitärkapazitäten vom höchstwertigen Bit MSB ausgehen und alle niedrigerwertigen Bits entsprechend kompensieren, bis eine entsprechende Gewichtung, beispielsweise eine binäre Gewichtung entsteht. Unter Umständen sind hierbei einige große Kapazitäten relativ stark zu kompensieren, insgesamt verbraucht diese Methode jedoch weniger Chipfläche als die vorhergehend beschriebene Methode, die vom LSB ausgeht.

Besonders vorteilhaft ist es, die gewichteten Streukapazitäten durch eine Kombination der beiden Methoden, nämlich die Parallelschaltung von positiven und negativ wirkenden Kapazitäten zu realisieren. Die benötigte Chipfläche läßt sich bei einer derartigen Kombination minimieren. Günstig ist es deshalb bei den niedrigerwertigen Kapazitäten, beispielswelse des Split-Kapazitätsnetzwerks das Kompensationsverfahren mit negativen Effektivkapazitäten anzuwenden, um deren Fehlerladung zu verringern. Den höchstwertigen Bits des Hauptkapazitätsnetzwerks werden dagegen weitere Streukapazitäten additiv parallelgeschaltet, um die Gesamtstreukapazität im Sinne der Gewichtung zu vergrößern. Dies zeigt das Teilnetzwerk SNH mit den Streukapazitäten CSA1 bis CSA5.

Auf diese Weise läßt sich eine effektive Gewichtung aller Streukapazitäten des gesamten Kapazitätsnetzwerks, d.h. die beiden Kapazitätsnetzwerke CN1 und CN2 erreichen. Werden bei der Realisierung der zusätzlichen zu realisierenden Kapazitäten jene Materialien und Topologien gewählt, die auch die natürlich vorhandenen Streukapazitäten ausmachen, läßt sich eine technologieunabhängige Gewichtung der Gesamtstreukapazitäten erreichen. Dies hat den Vorteil, daß sich das gesamte parasitäre Netzwerk bei Parameterschwankungen insgesamt gleich verhält.

## Patentansprüche

1. Digital-Analog-Wandler mit kapazitivem Wandlernetzwerk bestehend aus gewichteten Nutzkapazitäten (CH1 bis CH16; CS1 bis CS16),
**gekennzeichnet durch**
Kompensationskapazitäten (CSA1 bis CSA5; CSS1 bis CSS16), die zu den im Wandlernetzwerk (CN1; CN2) vorhandenen Streukapazitäten (SCH1 bis SCH 16; SCS1 bis SCS16) derart parallel geschaltet und dimensioniert sind, daß die jeweiligen Gesamtkapazitätswerte aus Streukapazitätswert und Kompensationskapazitätswert entsprechend den Nutzkapazitätswerten gewichtet sind.

2. Wandler nach Anspruch 1,
**dadurch gekennzeichnet**, daß
für höherwertige Kapazitäten des Wandlernetzwerks die Kompensationskapazitätswerte (CSA1, CSA2) zu den Streukapazitätswerten addiert werden.

3. Wandler nach einem der Ansprüche 1 oder 2,
**dadurch gekennzeichnet**, daß
zu den Streukapazitäten des Wandlernetzwerks Kompensationskapazitäten (CSS1 bis CSS16) mit effektiv, d. h. in ihrer Wirkung, negativer Kapazität parallel geschaltet werden.

4. Wandler nach Anspruch 3,
**dadurch gekennzeichnet**, daß
die negativen Kapazitäten durch Kompensationskapazitäten mit gegenphasiger Ansteuerung gebildet sind.

5. Wandler nach einem der Ansprüche 1 bis 4,
**gekennzeichnet durch**
eine Kombination aus Kompensationskapazitäten mit positiven bzw. negativ wirkenden Kapazitäten.

6. Wandler nach einem der Ansprüche 1 bis 5,
**gekennzeichnet durch**
ein geteiltes Wandlernetzwerk.

7. Wandler nach einem der Ansprüche 2 bis 6,
**dadurch gekennzeichnet**, daß
die Kompensationskapazitäten aus gleichen Materialien und mit gleichen Topologien wie die Streukapazitäten gebildet sind.

## Claims

1. Digital/analogue converter having a capacitive converter network comprising weighted useful capacitors (CH1 to CH16; CS1 to CS16), characterized by compensation capacitors (CSA1 to CSA5; CSS1 to CSS16) which are connected in parallel with the parasitic capacitors (SCH1 to SCH16; SCS1 to SCS16) present in the converter network (CN1; CN2), and are dimensioned, such that the respective total capacitance values, comprising parasitic capacitance value and compensation capacitance value, are weighted in accordance with the useful capacitance values.

2. Converter according to Claim 1, characterized in that, for capacitors with a relatively high value in the converter network, the compensation capacitance values (CSA1, CSA2) are added to the parasitic capacitance values.

3. Converter according to one of Claims 1 and 2, characterized in that compensation capacitors (CSS1 to CSS16) whose capacitance is effectively negative, that is to say has a negative action, are connected in parallel with the parasitic capacitors in the converter network.

4. Converter according to Claim 3, characterized in that the negative capacitors are formed by compensation capacitors driven in antiphase.

5. Converter according to one of Claims 1 to 4, characterized by a combination of compensation capacitors having positive and negatively acting capacitances.

6. Converter according to one of Claims 1 to 5, characterized by a split converter network.

7. Converter according to one of Claims 2 to 6, characterized in that the compensation capacitors are formed from the same materials and with the same topologies as the parasitic capacitors.

## Revendications

1. Convertisseur numérique-analogique à réseau convertisseur capacitif composé de capacités effectives pondérées (CH1 à CH16 ; CS1 à CS16), caractérisé par des capacités de compensation (CSA1 à CSA5 ; CSS1 à CSS16) qui sont mises en parallèle avec les capacités parasites (SCH1 à SCH16 ; SCS1 à SCS16) présentes dans le réseau convertisseur (CN1 ; CN2) et qui sont dimensionnées de telle sorte que les valeurs globales respectives de la capacité composées de la valeur de la capacité parasite et de la valeur de la capacité de compensation sont pondérées selon les valeurs de la capacité effective.

2. Convertisseur selon la revendication 1, caractérisé en ce que pour des capacités de valeur plus élevée du réseau convertisseur, les valeurs de la capacité de compensation (CSA1, CSA2) et les valeurs de la capacité parasite sont additionnées.

3. Convertisseur selon l'une des revendications 1 ou 2, caractérisé en ce que les capacités parasites du réseau convertisseur sont mises en parallèle avec des capacités de compensation (CSS1 à CSS16) à capacité effectivement négative, c'est-à-dire négative dans leur effet.

4. Convertisseur selon la revendication 3, caractérisé en ce que les capacités négatives sont formées par des capacités de compensation à commande en opposition de phase.

5. Convertisseur selon l'une des revendications 1 à 4, caractérisé par une combinaison de capacités de compensation avec des capacités à effet respectivement positif et négatif.

6. Convertisseur selon l'une des revendications 1 à 5, caractérisé par un réseau convertisseur partagé.

7. Convertisseur selon l'une des revendications 2 à 6, caractérisé en ce que les capacités de compensation sont réalisées à partir des mêmes matières et avec les mêmes topologies que les capacités parasites.
